# EUROPEAN PATENT APPLICATION

(11) **EP 2 190 191 A2**
(43) Date of publication of application: **26.05.2010**
(21) Application number: 09170020.3
(22) Date of filing: 11.09.2009
(51) Int. Cl.: H04N 5/76

(54) **Automotive entertainment system**

(30) Priority: 30.10.2008 GB 0819860
(71) Applicant: Nissan Motor Manufacturing (UK) Ltd., Cranfield Bedfordshire MK43 0DB (GB)
(72) Inventor: Williams, John, Cranfield, Bedfordshire MK43 0DB (GB)

(57) **Abstract**

A vehicle entertainment system (10, 110, 210) comprising: receiver means (20) for receiving a broadcast audiovisual signal; display means (12) for displaying the broadcast audiovisual signal; and means (14, 16) for communicating with a storage means (24, 124, 224) to initiate recording of the broadcast audiovisual signal in the storage means (24, 124, 224).

## Description

The present invention relates to entertainment systems for vehicles, and in particular, but not exclusively, to a system for contacting a signal recording device remote from the vehicle in order to record a signal selected onboard the vehicle.

Modem passenger vehicles are equipped with sophisticated audiovisual equipment. It is increasingly common for cars to be provided with televisions (TVs) which receive a terrestrial or satellite TV signal. However legislation dictates that the driver is only permitted to watch the television when the vehicle is stationary on-highway (for example in a traffic jam) or off-highway (for example in a car park). As soon as the vehicle is moving on the highway, any display visible by the driver must be switched off, although rear seat displays may remain on.

It is not uncommon therefore for the driver to begin watching a television program (for example whilst stationary in a traffic jam) only then to be prevented from continuing to watch once the vehicle is moving. This is frustrating as the driver then cannot view the remaining part of the program.

A known solution to this problem is to provide an onboard hard drive onto which the TV signal is recorded when the display switches off. This recorded signal can then be viewed once the vehicle is stationary once again. Whilst this works well in allowing the driver to view a program in stop/start traffic, it is unsatisfactory in the event that the driver is stopped for a longer period of time before subsequently driving continuously to his or her destination. This turn of events is particularly frustrating since the driver often moves continuously following a stationary period and therefore does not have an opportunity to view the saved program unless they remain in the vehicle once they have reached their destination.

This is inconvenient and presents a significant barrier to use of such a system since the saved program is only stored onboard the vehicle and is not available for viewing elsewhere.

It is an object of the invention to at least mitigate some of the above problems.

Aspects of the invention therefore provide a vehicle entertainment system as claimed in the appended claims.

According to another aspect of the present invention there is provided a vehicle entertainment system comprising:
a receiver for receiving a broadcast audiovisual signal;
a display for displaying the broadcast audiovisual signal;
means for switching off the display when the speed of the vehicle exceeds a predetermined value; and
means for initiating communication with a storage means to initiate recording of the broadcast audiovisual signal in the storage means.

This is advantageous in that the display of the broadcast audiovisual signal (typically a television or radio program) which is switched off in the vehicle is automatically recorded. In this way the driver is able to continue watching the program that was switched off in the vehicle upon his or her arrival at home, or other destination.

Preferably recording of the broadcast audiovisual signal by the storage means is initiated automatically when the speed of the vehicle exceeds the predetermined value.

Advantageously this feature can be set to control the recording of the broadcast autonomously, without the need to disturb the driver by requesting confirmation each time the vehicle moves.

Preferably the display is a dashboard mounted television display and the receiver means (20) comprises a terrestrial TV signal receiver or a satellite TV signal receiver.

The entertainment system may be provided with multiple displays which are visible to the or each passenger. However the greatest benefit of the system is realised by the driver whose display must cease displaying the television broadcast if the vehicle is being driven on public roads.

Preferably the means for switching off the display and initiating communication with the storage means is a microprocessor.

Preferably, the storage means is a personal video recorder or hard drive recorder.

More preferably, the storage means is located remote from the vehicle, for example at the driver's destination and takes the form of a remote storage device.

Preferably the communication means is a mobile telephone.

Preferably the mobile telephone communicates with the remote storage device by SMS or email.

According to another example of the present invention, the entertainment system is provided with an on-board storage device configured to record at least part of the audiovisual broadcast and to allow the user to view the recorded audiovisual broadcast once the vehicle speed falls below a pre-determined value and, wherein the on-board storage device is configured to record continually the audiovisual broadcast signal on a rolling memory basis.

Preferably the system comprises a remote storage device configured to send a confirmation signal to the system in the vehicle confirming commencement of recording by the remote storage device, receipt of said confirmation signal causes the on-board storage device to stop recording.

Advantageously this feature prevents the lost signal from failing to be recorded by the driver, as there is potential for a delay between the vehicle starting to move and the storage means starting to record the audiovisual broadcast signal.

According to another example of the present invention, the entertainment system is provided with a communications port configured to permit the user to download the recorded audiovisual broadcast signal from the on-board storage device to a portable storage device.

Advantageously this feature allows the user to view the entirety of the missed audiovisual broadcast at a time and in a location convenient to the user. This feature also allows for a relatively small capacity on-board storage device which may be easily downloaded to an external storage device. In this way the on-board storage device may be provided by a partition of a hard drive or allocation of memory which is shared by other systems already integrated into the vehicle.

According to a yet further aspect of the present invention there is provided a method of recording a broadcast audiovisual signal remotely from a vehicle which receives the signal, the method comprising the steps of:
providing a receiver on the vehicle for receiving a broadcast audiovisual signal;
providing a display on the vehicle for displaying the broadcast audiovisual signal;
detecting the speed of the passenger vehicle;
switching off the display when the speed of the vehicle exceeds the predetermined value;
providing an audiovisual signal storage device remote from the vehicle;
communicating with the remote storage device to initiate recording of the broadcast signal.

Preferably the step of communicating with the remote storage device to initiate recording of the broadcast signal is initiated automatically when the speed of the vehicle exceeds the predetermined value.

According to a still further aspect of the present invention there is provided a vehicle entertainment system, the system including:
a receiver for receiving a broadcast audiovisual signal;
a display for displaying the broadcast audiovisual signal;
means for detecting the location of the vehicle to determine whether the vehicle is on-highway or off-highway;
storage means for storing the broadcast audiovisual signal in the event that the vehicle moves from an off-highway location to an on-highway location.

This provides the advantage that the broadcast audiovisual signal begins to be recorded at the same time as the display switches off upon the vehicle entering the on-highway network. As a result none of the program being watched by the driver is lost.

Examples of the invention will now be described, by way of example only, with reference to the Figures, in which:
Figure 1 is a schematic representation of the system according to the present invention.
Figure 2 is a schematic representation of the system according to another example of the present invention.
Figure 3 is a schematic representation of the system according to a further example of the present invention.

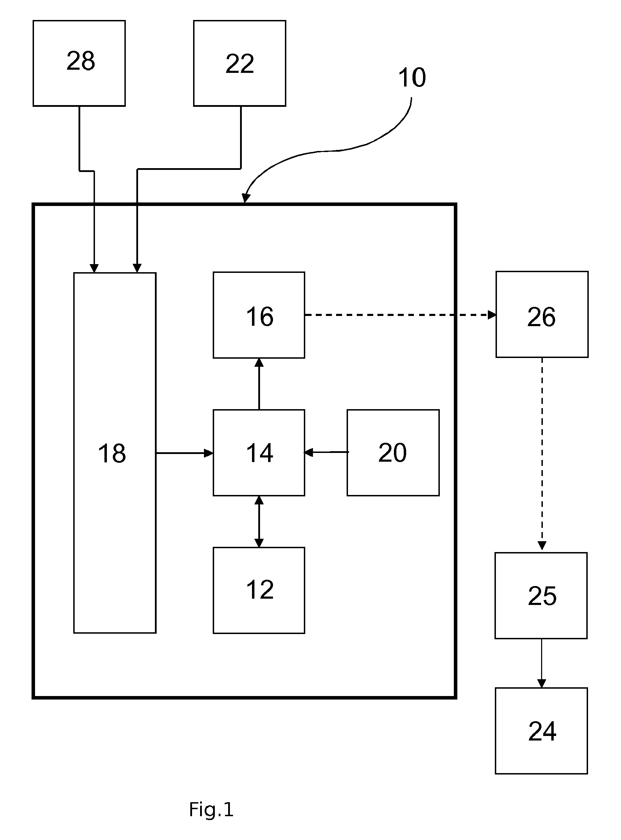

In Figure 1 a vehicle entertainment system 10 is shown having a dashboard mounted televisual display 12, a microprocessor 14 and a Bluetooth^{™} transmitter 16 and a user interface 18. The display 12, transmitter 16 and user interface 18 are controlled by the microprocessor 14. The display 12 displays, inter alia, audiovisual signals in the form of, for example television programs. The signal is received by a receiver 20. The receiver 20 comprises a tuner and/or decoder and an antenna for receiving and decoding broadcast audiovisual signals. The receiver 20 is also in communication with the microprocessor 14. The receiver 20 and microprocessor 14 are configured to receive analogue or digital terrestrial television or radio signals, or satellite television or radio signals.

When the vehicle is stationary, the display 12 shows the audiovisual signal being received by the receiver 20. However, once the vehicle has started to move over a predetermined speed, typically 0 miles per hour, legislation dictates that the display can no longer be used as a television and the microprocessor 14 prevents the display being used as a television display.

In order to detect when the vehicle is moving above the predetermined speed, the microprocessor 14 receives a speed data signal, indicated at 22 in Figure 1, relating to vehicle speed and/or location. This data signal 22 is provided by either the vehicle management system or the satellite navigation system in a known manner.

The system 10 has the capability to communicate with a storage means. The storage means may take the form of an integrated on-board storage device and/or an off-board or remote storage device. In the example shown in Figure 1 the storage device takes the form of a remote storage device 24 which is located outside of the vehicle. In this case, the remote storage device 24 may take the form of a personal video recorder (VCR), personal DVD recorder or hard drive storage device (PVR) such as the Sky+^{™} system. The remote storage device 24 is typically located at the driver's home but could equally be located at any location remote from the vehicle. The storage device has an associated receiver and antenna 25 for receiving the same audiovisual signal received by the entertainment system antenna 20.

The system 10 communicates with the remote storage device 24 via a mobile phone 26 and transmitter 16. The mobile phone 26 may be carried by the user travelling in the vehicle or alternatively may be integrated into the vehicle itself. To initiate recording of the audiovisual signals, the transmitter 16 sends a signal to the mobile phone 26 instructing it to contact the storage device 24 to issue a command to commence recording the signal received by the antenna 25. Communication between the phone 26 and storage device 24 is by SMS, although could equally be by email or other known communication method such as a data phone call.

In use, when the vehicle exceeds the predetermined speed, the microprocessor 14 informs the driver that the speed has been exceeded via the display 12 and asks the driver whether the previously displayed audiovisual signal should be recorded by the remote storage device 24. In response to a driver input 28 via the user interface 18, the microprocessor 14 controls the transmitter 16 to instruct the mobile phone 26 to communicate with the remote storage device 24 via SMS to initiate recording of the signal.

Alternatively, the step of informing the driver is omitted and the microprocessor 14 automatically initiates recording of the signal as described above in response to the vehicle speed exceeding the predetermined value.

It will be appreciated that the above invention applies primarily to displays visible by the driver and that displays visible only by a front seat passenger or rear seat occupant may remain on whilst the vehicle is moving.

It will be appreciated by one skilled in the art that the audio content of the broadcast may be replayed by the system either by dedicated loud speakers with an associated amplifier or alternatively via an existing vehicle audio system.

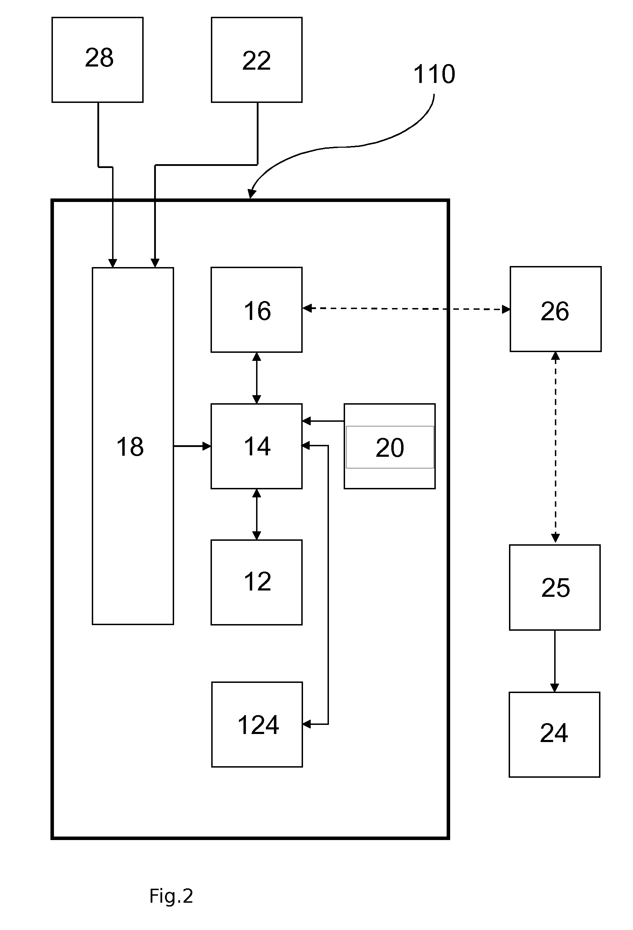

In another example shown in Figure 2, the system 110 is provided with an on-board storage device 124 to record the audiovisual signal. The system is configured to allow the user to view the recorded audiovisual signal at a time when the vehicle is stationary or via a display not visible to the driver. Alternatively or in addition, the system 110 may record an audiovisual signal being viewed by the user on a continual or rolling memory basis. In this way, no part of the audiovisual signal is lost during the process of communicating to the remote storage device 24 to commence recording.

In use, when the vehicle exceeds the predetermined speed, the microprocessor 14 informs the driver that the speed has been exceeded via the display 12 and asks the driver whether the previously displayed audiovisual signal should be recorded by the remote storage device 24. In response to a driver input 28 via the user interface 18, the microprocessor 14 controls the on-board storage device 124 and initiates recording of the audiovisual signal. The system 110 then communicates with the remote storage device 24 via a mobile phone 26 and transmitter 16. In the same way as previously described for system 10.

Preferably, the remote storage device 24 is provided with the facility to communicate back to the system 110 to confirm that recording of the desired audiovisual signals has begun. On receipt of this communication back from the remote storage device 24 the system 110 can stop recording the audiovisual signal onto the on-board storage device 124.

When the vehicle has completed the journey, identified by the driver selecting park or turning off the engine ignition, the system 110 then informs the driver via the display 12 of the duration of the recording held on the on-board storage device 124. This recording was started when the vehicle started moving and stopped when the system 110 received confirmation that the remote storage device 24 had started recording. The driver is then given the option to view the recording stored on the on-board storage device 124 either immediately or to store it for viewing later.

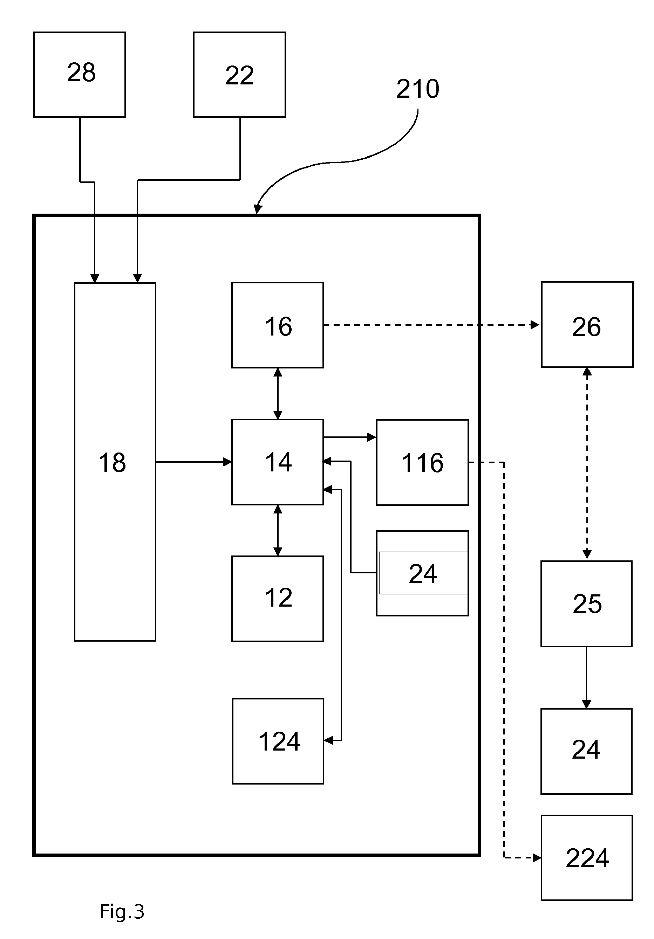

In a further example, shown in Figure 3 the system 210 is provided with a data communication port 116. The data communication port 116 may be a wired and/or wireless link to access the recorded data on the on-board storage device 124. The data communication port 116 may take the form of a USB, IEE1394, 802.11g, 802.11n or other suitable digital communication port. The communication port 116 is configured to allow the connection of a remote storage device such as a portable storage device 224 to the on-board storage device 124 of the system 210.

In use, the system 210 functions in much the same way as the system 110 of the previous example, except that the driver is offered additional options at the end of the journey. When the vehicle journey is complete, the driver is offered the options of viewing the audiovisual signals recorded on the on-board storage device 124 immediately or at a later time via the display 12, or to transfer that recording via the data communication port 116 to a remote storage device such as a portable storage device 224.

In this way, the audiovisual signal recorded on the on-board storage device 124 may be transferred to the portable storage device 224, allowing the user to view the audiovisual signal in a location remote from the vehicle.

This also provides the advantage that any part of the audiovisual broadcast program not recorded by the remote storage device 24, due to any delay in receiving a command to start recording by the system 210, is still available as it was captured by the on-board storage device 124.

It will be appreciated that within the scope of the example described above as system 210, the function of the remote storage device 24 may be performed by a portable storage device 224.

## Claims

1. A vehicle entertainment system (10, 110, 210) comprising:
receiver means (20) for receiving a broadcast audiovisual signal;
display means (12) for displaying the broadcast audiovisual signal; and
means (14, 16) for communicating with a storage means (24, 124, 224) to initiate recording of the broadcast audiovisual signal in the storage means (24, 124, 224).

2. The system (10, 110, 210) according to claim 1, comprising means (14) for switching off the display means in dependence on a vehicle running condition.

3. The system (10, 110, 210) according to claim 1 or claim 2 wherein recording of the broadcast audiovisual signal in the storage means (24, 124, 224) is initiated automatically in dependence on a vehicle running condition (22).

4. The system (10, 110, 210) according to claim 2 or claim 3, wherein the vehicle running condition (22) comprises the speed of the vehicle exceeding a predetermined value.

5. The system (10, 110, 210) according to any preceding claim wherein the display means (12) comprises a dashboard mounted television display and, wherein the receiver means (20) comprises a terrestrial TV signal receiver or a satellite TV signal receiver.

6. The system (10, 110, 210) according to any preceding claim wherein the means (14) for switching off the display (12) and the means (14, 16) for communicating with the storage means (24, 124, 224) comprise a microprocessor.

7. The system (10, 110, 210) according to any preceding claim wherein the storage means (24, 124, 224) comprises a personal video recorder or hard drive recorder.

8. The system (110) according to any preceding claim wherein the storage means is remote from the vehicle and takes the form of a remote storage device (124).

9. The system (10, 110, 210) according to any preceding claim wherein the communication means comprises a mobile telephone (26).

10. The system (10, 110, 210) according to claim 9 wherein the mobile telephone (26) communicates with the storage means (24, 124) by SMS or email.

11. The system (210) according to any preceding claim wherein the entertainment system (210) is provided with an on-board storage device (124) configured to record at least part of the audiovisual broadcast and to allow the user to view the recorded audiovisual broadcast once the vehicle speed falls below a pre-determined value and, wherein the on-board storage (124) device is configured to record continually the audiovisual broadcast signal on a rolling memory basis.

12. The system (10, 110, 210) according to claim 10 or claim 11 wherein the system (10, 110, 210) comprises a remote storage (24) device configured to send a confirmation signal to the system (10, 110, 210) in the vehicle confirming commencement of recording by the remote storage (24) device and wherein the receipt of said confirmation signal causes the on-board (124) storage device to stop recording.

13. The system (10, 110, 210) according to claim 11 or claim 12 wherein the entertainment system (10, 110, 210) is provided with a communications port (116) configured to permit the user to download the recorded audiovisual broadcast signal from the on-board storage device (124) to a portable storage device (224).

14. A method of recording a broadcast audiovisual signal received by a vehicle, the method comprising the steps of:
receiving the broadcast audiovisual signal;
displaying the broadcast audiovisual signal;
detecting a running condition (22) of the vehicle;
switching off the display (12) in dependence on the running condition (22) of the vehicle; and
communicating with a storage device to initiate recording of the broadcast audiovisual signal.

15. A vehicle entertainment system (10, 110, 210) comprising:
a receiver (20) for receiving a broadcast audiovisual signal;
a display (12) for displaying the broadcast audiovisual signal;
means (22) for detecting the location of the passenger vehicle to determine whether the vehicle is on-highway or off-highway;
storage means (24, 124) for storing the broadcast audiovisual signal in the event that the vehicle moves from an off-highway location to an on-highway location.
